# EUROPEAN PATENT APPLICATION

(11) **EP 1 024 525 A1**
(43) Date of publication of application: **02.08.2000**
(21) Application number: 99830037.0
(22) Date of filing: 28.01.1999
(51) Int. Cl.: H01L 21/74, H01L 29/08, H01L 23/66

(54) **Integrated power structure for radio-frequency applications**

(71) Applicant: STMicroelectronics S.r.l., 20041 Agrate Brianza (Milano) (IT)
(72) Inventor: Santangelo, Antonello, 95032 Belpasso (Catania) (IT)
(74) Representative: Pezzoli, Ennio

(57) **Abstract**

Integrated power structure (100) for radio-frequency applications, formed in a chip of semiconductor material comprising, between a first (187) and a second (184) surface which are opposite each other, a substrate (103) on which at least one epitaxial layer (106, 112) is grown, the integrated structure (100) including at least one transistor (Tp) formed in an insulated portion (109, 142) of the chip and having a power terminal (E) located on the second surface (184), and at least one connection region (130, 136) in contact with the power terminal (E) and extending from the second surface (184) to the substrate (103) to electrically connect the power terminal (E) to the first surface (187), the at least one connection region (130, 136) comprising a groove (127) which extends from the second surface (184) to the substrate (103) and is filled with doped polysilicon (130).

## Description

The present invention relates to an integrated power structure for radio-frequency applications, and in particular to an integrated structure according to the preamble of the first claim.

Integrated power structures (designed to operate with high currents and/or voltages, for example those ranging from a few hundred mA to several A and from about ten V to about a hundred V) are widely used in radio-frequency applications in which the operating frequencies are very high, for example ranging from a few tens of MHz to several GHz. Typically, these applications require the use of an amplifier stage with transistors having a power terminal connected to a reference (or ground) terminal, such as for example a bipolar transistor having its emitter terminal connected to the ground terminal (common-emitter configuration).

The integrated power structure is formed in a chip of semiconductor material consisting of a substrate on which one or more epitaxial layers are grown. The chip is housed in a suitable metal container (case); in particular, a lower surface of the chip (consisting of a free surface of the substrate) is fixed on a base of the metal container, which is typically connected to ground.

Since the emitter terminal is formed on an upper surface of the chip (opposite the lower surface), the emitter terminal has to be connected electrically, by metal wires, to the base of the case (connected to ground). However, the metal connecting wires introduce parasitic inductances which adversely affect the operating characteristics of the corresponding complete electronic device; this generally means that a plurality of metal wires (connected in parallel to each other) have to be used in order to reduce the total parasitic inductance. In any case, the process of encapsulation of the structure becomes more complicated and difficult, thus increasing the cost of the electronic device.

In the particular case in which the collector terminal of the bipolar transistor is formed on the lower surface of the chip, it is also necessary to provide a layer of dielectric material which insulates the collector terminal from the base of the metal case (which is connected to ground). The dielectric layer is formed from a material, such as beryllium oxide, having high thermal conductivity; however, this material is extremely expensive and toxic. Moreover, the layer of dielectric material creates problems of heat dissipation, since it reduces the transfer to the exterior of the heat generated by the integrated power structure.

The object of the present invention is to overcome the aforesaid drawbacks. To achieve this object, an integrated power structure as described in the first claim is proposed.

Briefly, the present invention provides an integrated power structure for radio-frequency applications, formed in a chip of semiconductor material comprising, between a first and a second surface which are opposite each other, a substrate on which at least one epitaxial layer is grown, the integrated structure including at least one transistor formed in an insulated portion of the chip and having a power terminal located on the second surface, and at least one connection region in contact with the power terminal and extending from the second surface to the substrate to electrically connect the power terminal to the first surface, the at least one connection region comprising a groove which extends from the second surface to the substrate and is filled with doped polysilicon.

The present invention also proposes an electronic device comprising this integrated structure and a corresponding method for producing the integrated structure.

Further characteristics and the advantages of the integrated power structure according to the present invention will be made clear by the following description of a preferred embodiment of the invention, provided for information and without restriction, with reference to the attached figures, in which:
Figs. 1a-1j show the various stages of a process for producing an example of an integrated structure according to the present invention;
Fig. 2 shows an electronic device comprising this integrated structure.

With joint reference to Figs. la-lj (the elements common to the different figures are identified by the same reference numbers), an integrated structure 100 formed in a chip of semiconductor material is illustrated; typically, the said structure is formed in large numbers in a plurality of identical areas of a wafer of semiconductor material, which are subsequently separated by a cutting operation. As usual, the concentrations of N type and P type impurities are indicated by adding the sign + or - to the letters N and P to indicate a high or low concentration of impurities respectively, or the sign ++ or the sign -- is added to indicate a very high concentration or a very low concentration of impurities respectively; the letters N and P without the addition of the signs + or - denote concentrations of intermediate value.

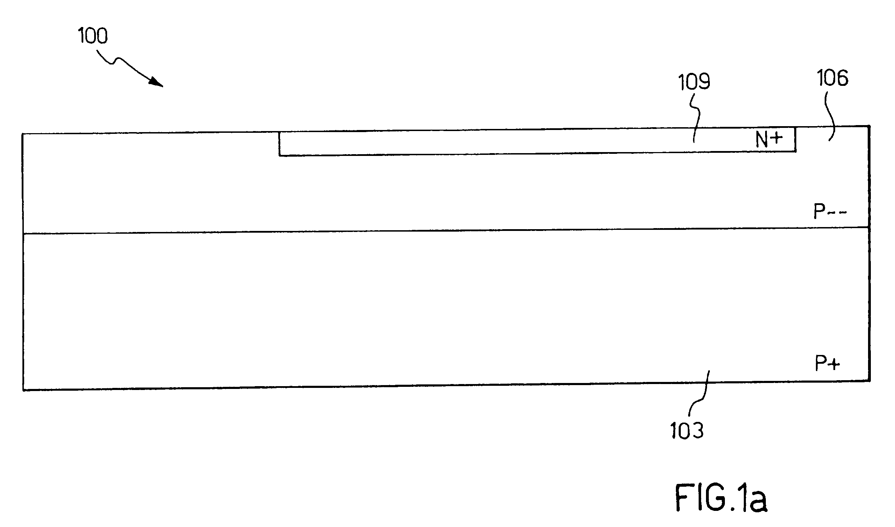

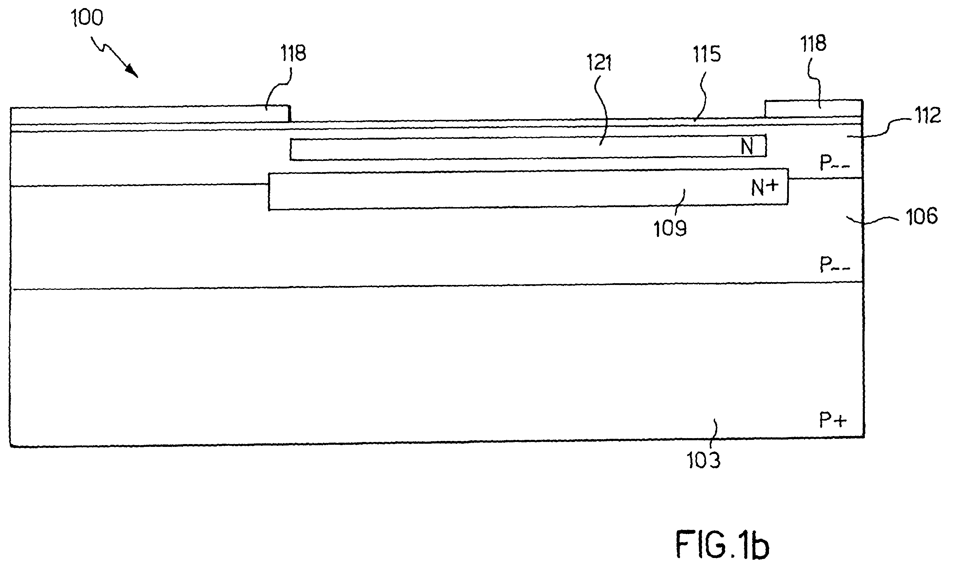

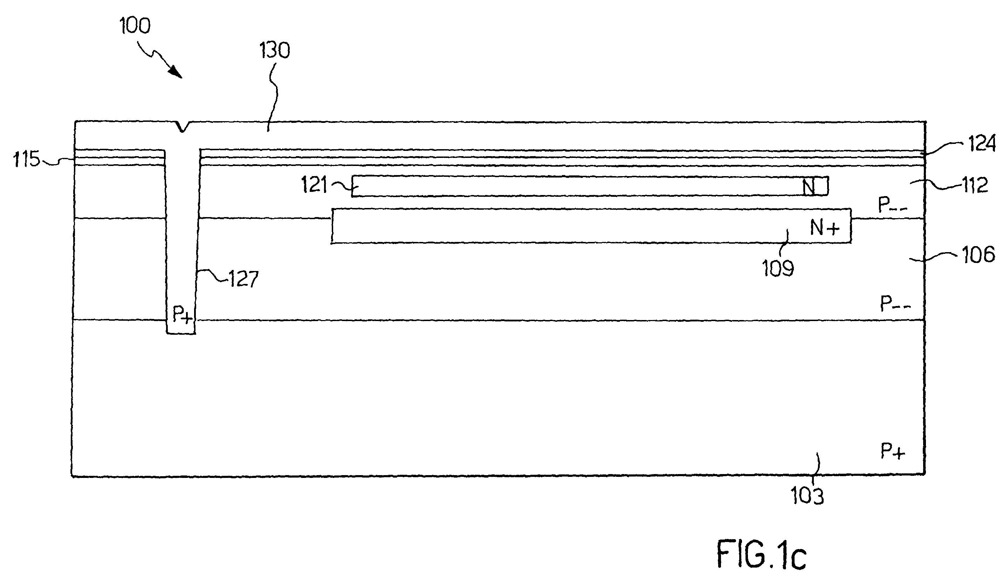

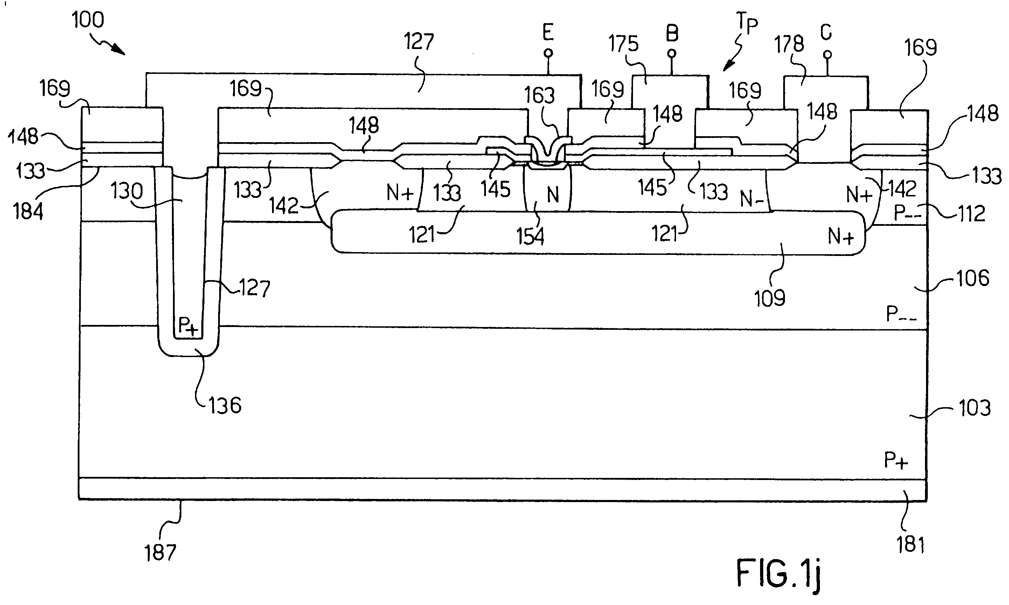

With reference in particular to Fig. 1a, the chip comprises a substrate 103, typically monocrystalline silicon, strongly doped with P type impurities (P+); a layer 106, having the same type of conductivity, but with a very low concentration of impurities (P--), is formed on the substrate 103 by means of epitaxial growth. A region 109, having a high concentration of N type impurities (N+), is formed on a free surface of the epitaxial layer 106 by a photolithographic masking process, a stage of ionic implantation and a stage of diffusion.

Moving on to Fig. lb, a second epitaxial layer 112 of the P-- type is formed on the free surface of the first epitaxial layer 106. In this stage, which is carried out at high temperature, the N type impurities implanted previously (region 109) are further diffused into the two epitaxial layers 106, 112, producing a buried region. A free surface of the second epitaxial layer 112 is subjected to an oxidation process which produces the growth of a layer of oxide 115 (silicon dioxide). A layer of photosensitive material (photoresist) 118 is deposited on the oxide layer 115 and is then shaped by a photolithographic process. An N type region 121 is implanted in the second epitaxial layer 112 through a window formed in the layer of photosensitive material 118; the region 121 is almost completely superimposed, in a plan view, on the buried region 109, leaving only an edge portion of this region uncovered.

At this point, the layer of photosensitive material 118 is removed (stripped), as illustrated in Fig. 1c. A thin layer (film) 124 of a different dielectric material, such as silicon nitride, is deposited on the oxide layer 115. A groove 127 extending to the substrate 103 is then formed by a photolithographic masking process and a dry etching stage (for example, a plasma process). The process continues with the deposition of a layer of polycrystalline silicon (polysilicon) 130, doped in situ with P+ type impurities (boron, for example), on the silicon nitride film 124 and on lateral walls of the groove 127; the layer of polysilicon 130 has a thickness such that it completely fills the groove 127 (with a slight depression next to the groove). Preferably, the width of the groove 127 (1 µm, for example) is substantially less than its depth (5 µm, for example); this enables the groove 127 to be filled by using a polysilicon layer 130 having a limited thickness.

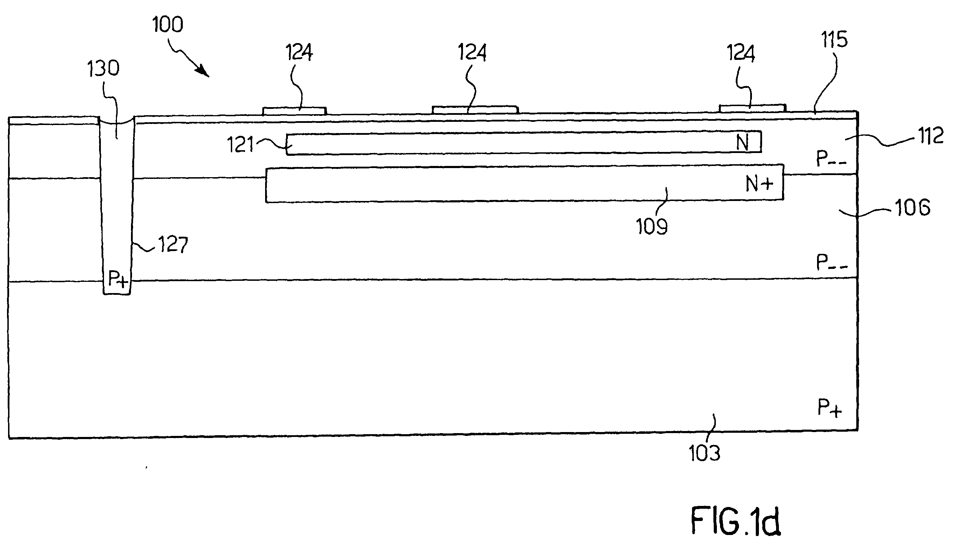

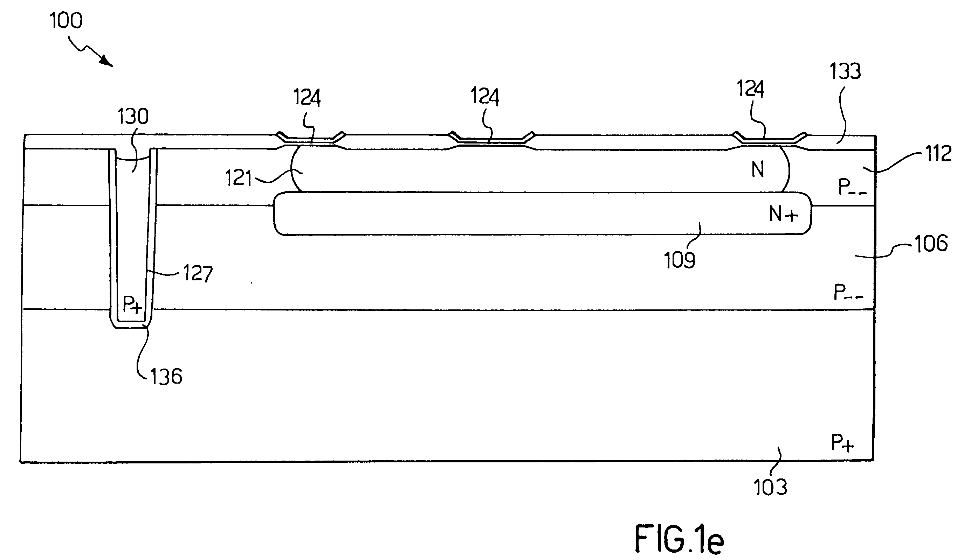

With reference now to Fig. 1d, the polysilicon layer 130 is removed completely (etch-back) next to the silicon nitride film 124, in such a way as to form a polysilicon connecting region (sinker) inside the groove 127. The silicon nitride film 124 is then selectively removed by a photolithographic masking process and an etching stage; in particular, an outer area is formed which is superimposed in plan view on the edge portion of the buried region 109 and an inner area is formed which is located, in plan view, within this outer area.

With reference to Fig. 1e, an oxidation process causes the growth of a further layer of silicon dioxide which forms, together with the pre-existing layer of silicon dioxide (indicated by 115 in Fig. 1d), a single oxide layer 133. During the oxidation process, a partial diffusion of the impurities present in the region 121 is produced; in this stage, the regions 109 and 121 are joined together, while the region 121 is diffused upwards until it reaches the free surface of the second epitaxial layer 112. At the same time, the impurities present in the connection region 130 are also diffused into the chip of semiconductor material in such a way as to create a P+ type border region 136.

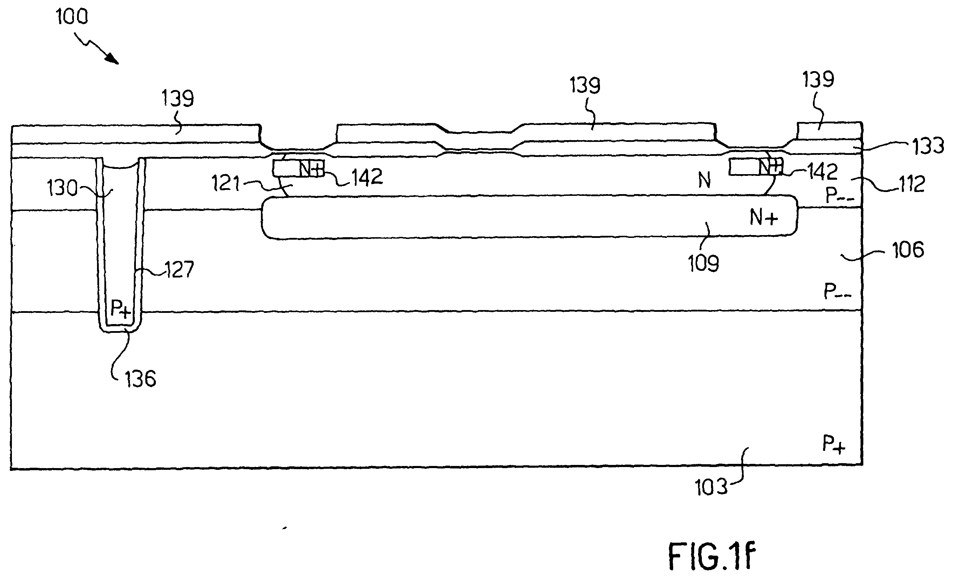

The remaining silicon nitride film 124 is removed by a wet etching process, as illustrated in Fig. 1f, in such a way as to leave corresponding thin areas of the oxide layer 133 exposed. A layer of photosensitive material 139 is deposited on the oxide layer 133 and is then shaped by a photolithographic masking process, in such a way that a window is formed above a thin outer area of the oxide layer 133, superimposed in plan view on the edge portion of the buried region 109. An N+ type region 142 is implanted in the chip of semiconductor material through this window.

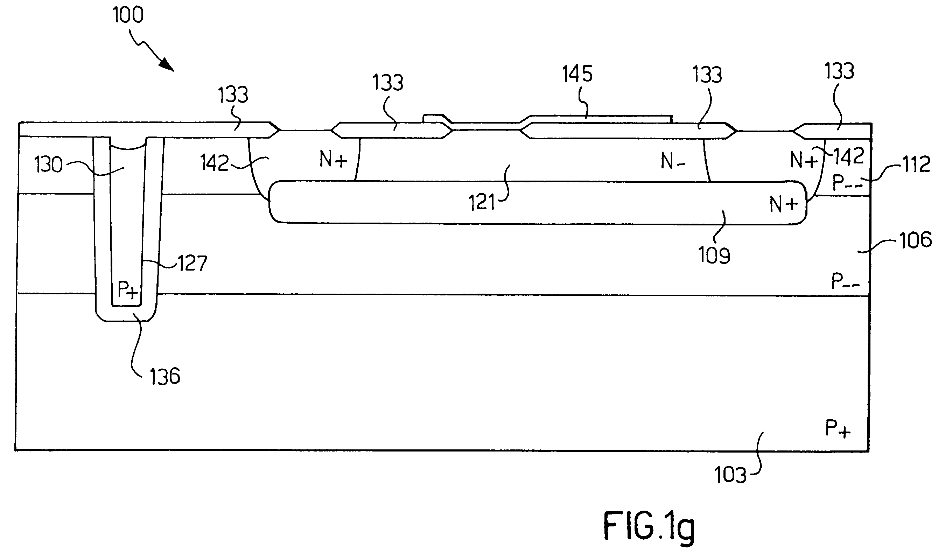

At this point the layer of photosensitive material 139 is removed, as shown in Fig. 1g. A further diffusion is then carried out. The region 142 is joined to the edge portion of the buried region 109 and is diffused upwards until it reaches the free surface of the second epitaxial layer 112, in such a way as to form a connection region; at the same time, the impurities present in the region 121 are redistributed inside this region (creating a uniformly doped N- type region) and the P+ type region 136 is diffused more deeply into the chip of semiconductor material. The thin area of the oxide layer 133 is subsequently removed by a wet etching process. The process continues with the deposition of a layer of polysilicon 145 doped with P type impurities (for example, boron) in the deposition phase or by a process of implantation over the whole of its free surface. The layer of polysilicon 145 is then selectively removed by a photolithographic masking process and an etching phase; the remaining layer of polysilicon 145 is located, in plan view, inside the connection region 142 and has a portion in contact with the region 121.

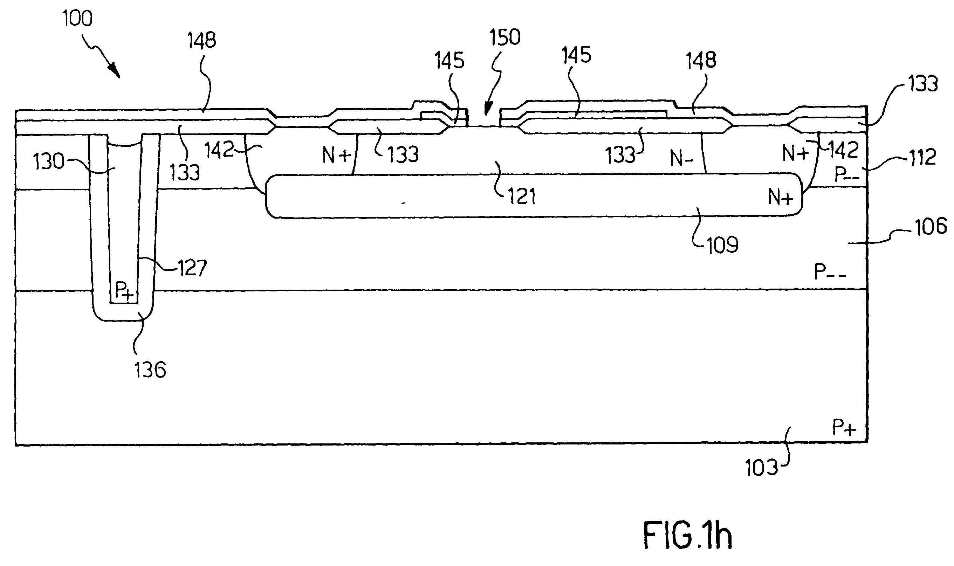

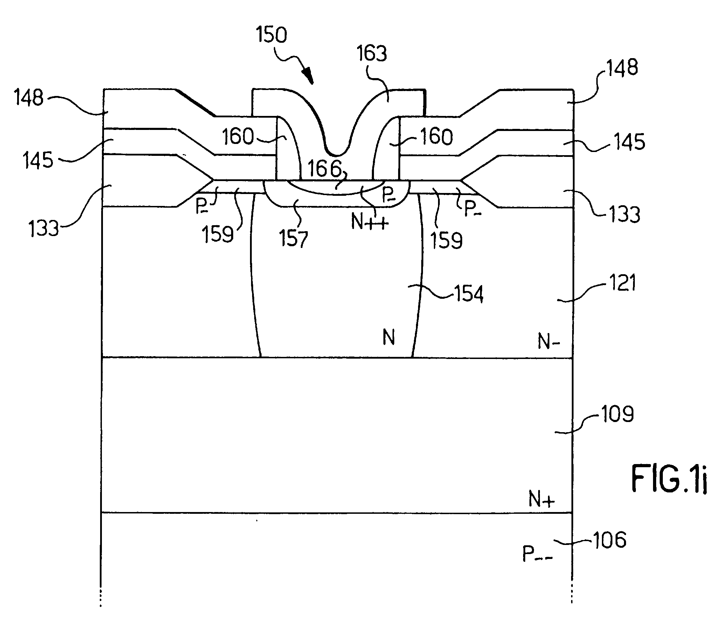

Moving on to Fig. 1h, a layer of dielectric material 148, for example silicon dioxide, is then deposited. A window 150, located, in plan view, inside the portion of the layer of polysilicon 145 in contact with the region 121, is formed by means of a photolithographic masking process and an etching phase in the layer of polysilicon 145 and in the layer of dielectric material 148.

With reference to the view in Fig. 1i of an enlarged detail of the integrated structure, N type impurities (for example phosphorus) are implanted through the window 150, using various implantation energies with various doses in such a way as to produce an N type region 154 at the end of various thermal processes (described below); the region 154 is uniformly doped and extremely confined laterally with respect to the window 150, and extends through the whole of the region 121 until it reaches the buried region 109. A P- type region 157 is then implanted through the window 150 in the region 154. A thermal process (including an oxidation phase) is then carried out, and during this process the P type impurities are diffused from the polysilicon layer 145 into the region 121 to form a P- type region 159 located around the window 150 and the previously implanted impurities (regions 154 and 157) are activated and diffused. A spacer 160 (made from dielectric material) is then formed on side walls of the window 150. A layer of polysilicon doped with N type impurities is deposited and shaped in such a way as to form a polysilicon region 163 in contact with a central portion of the region 157. A further thermal process is then carried out, during which the N type impurities are diffused from the polysilicon region 163 into the region 157 to form an N++ type region 166.

Returning to an overall view of the integrated structure, as illustrated in Fig. 1j, the chip is covered with a layer of dielectric material 169 (for example silicon oxide) which is planarized by a chemical mechanical polishing (CMP) process; alternatively, a dielectric material which flows back at relatively low temperatures (such as silicon oxide doped with boron and phosphorus, or BPSG) is used, or a material in the liquid state is deposited and the wafer of semiconductor material is then centrifuged, in such a way that the dielectric material spreads over the whole surface, after which it is dried. By means of a photolithographic masking process and an etching phase, contact windows are then formed in the layer of dielectric material 169 for conducting tracks (which, for example, may be metallic), which are formed by successive photolithographic masking processes, deposition phases and etching phases. In particular, a metallic track 172 contacts (and interconnects) the polysilicon region 163 and the connection region 130, 136, a metallic track 175 contacts the polysilicon layer 145, and a metallic track 178 contacts a portion of the connection region 142. Finally, a metallic layer 181 is deposited on a free surface of the substrate 103.

The integrated structure 100 described above includes a bipolar NPN transistor, Tp. In particular, the region 154 (located within the region 121) is a selective collector region and the region 109 is a buried collector region (these guide the collector current along a low-resistance path, so that the saturation voltage of the bipolar transistor Tp is reduced); the connection region 142 connects the regions 121, 154, 109 to the metallic track 178, which forms a collector terminal C. With reference jointly to Figs. 1i and 1j, the region 157 is an intrinsic base region, which forms the truly active region in the operation of the bipolar transistor Tp. The region 159 is an extrinsic base region which, together with the polysilicon layer 145, connects the intrinsic base region 157 through a low-resistance path to the metallic track 175, which forms a base terminal B. The P-N junction formed by the regions 157 and 166 forms a base-emitter junction of the bipolar transistor Tp, while the polysilicon region 163 is a polycrystalline emitter region, which is connected to the metallic track 172, which forms an emitter terminal E.

The bipolar transistor Tp is formed in an insulated portion of the chip of semiconductor material. In an operating condition, the emitter terminal E and the collector terminal C are connected to the ground terminal and to the positive terminal of a power source (whose negative terminal is connected to the ground terminal), respectively, so that the P-N junction formed by the epitaxial layers 106, 112 and by the regions 109, 142 is reverse biased.

It should also be noted that the integrated structure additionally includes a parasitic PNP transistor formed by the regions 157, 159 (emitter), the regions 154, 121, 109, 142 (base) and the regions 112, 106, 103 (collector); this parasitic transistor, however, has a highly doped base region (regions 109, 142), and therefore its gain is extremely low.

In the structure described above, the epitaxial layers 106, 112 have a very low concentration of impurities; preferably, their doping is such that the epitaxial layers 106, 112 have a resistivity greater than approximately 0.2 Ωm. Thus a depletion region formed between the regions 109, 142 and the epitaxial layers 106, 112 extends very deeply into the epitaxial layers 106, 112; therefore, a parasitic capacitance between the regions 109, 142 (collector) and the substrate 103 (emitter) has a very low value (being inversely proportional to the width of the depletion region).

However, the present invention can also be embodied in a bipolar transistor of another type (or one produced by another process), with a different number of epitaxial layers (even a single layer), with the P and N type regions interchanged, and the like; in general, the structure is integrated in a chip of semiconductor material comprising, between a lower surface and an upper surface which are opposite each other, a substrate on which at least one epitaxial layer is grown. Similar considerations are applicable if use is made of a transistor of a different type, for example a MOS field-effect transistor and, more generally, any transistor formed in an insulated portion of the chip and having a power terminal located on the upper surface.

In the integrated structure according to the present invention, the connection region 130, 136 is in contact with the emitter terminal E (or with a source terminal in the case of a MOS transistor) and extends from the upper surface of the chip, indicated by 184 and consisting, in the illustrated example, of the free surface of the second epitaxial layer 112, to the substrate 103; thus the emitter terminal E is connected electrically to the lower surface of the chip, indicated by 187 and consisting, in the illustrated example, of a free surface of the metallic layer 181. This result is achieved directly inside the said chip of semiconductor material, without any additional external connection.

The formation of the connection region 130, 136 by the formation of the groove 127 and its subsequent filling with doped polysilicon enables the connection region 130, 136 to be kept very narrow (with a width of even less than 1 µm, for example), thus reducing the space taken up on the chip of semiconductor material. Moreover, this structure enables a low resistance of the connection region 130, 136 to be obtained, so that a series emitter resistance of the bipolar transistor Tp is reduced. For example, in the case of a groove having, in plan view, the shape of a 1 µm x 1 µm square and a depth of 5 µm, the resistance of the connection region 130, 136 may decrease to approximately 200 Ω; this result is very difficult to achieve with other processes, owing to the great depth of the connection region 130, 136.

Preferably, the connection region 130, 136 is arranged, in plan view, in the form of a frame which completely surrounds the bipolar transistor Tp. The connection region 130, 136 (with high P type doping) thus blocks any superficial inversion layers of the epitaxial layer 112 (with low P type doping) due to electrical fields which cause an increased density of negative electrical charges on the free surface of the epitaxial layer 112 (with consequent formation of an N type surface layer). However, the integrated structure according to the present invention can also be made with a connection region which does not completely surround the bipolar transistor, and which is arranged, in plan view, to form, for example, a strip, a square, a circle, or the like. Alternatively, two or more connection regions, connected in parallel with each other, may be used, in such a way that the series emitter resistance of the bipolar transistor is further reduced.

In a different embodiment of the present invention, a plurality of bipolar transistors (similar to that described above) are provided and are connected, in parallel with each other, to the metallic tracks 172, 175, 178, in such a way as to form a plurality of elementary cells of the integrated structure. The number, arrangement and size of the elementary cells are chosen, for example, in such a way as to prevent an excessive current flow through the metallic tracks 172, 715, 178 (which might give rise to ionic migration phenomena) or in such a way as to minimize a parasitic capacitance between the metallic tracks 172, 175, 178 and the epitaxial layer 112 (connected to the emitter terminal). It should also be noted that, by omitting the metallic track 172 at the position of one or more of the elementary cells, it is possible to use these elementary cells to form analog/digital circuits which are electrically insulated from the integrated power structure.

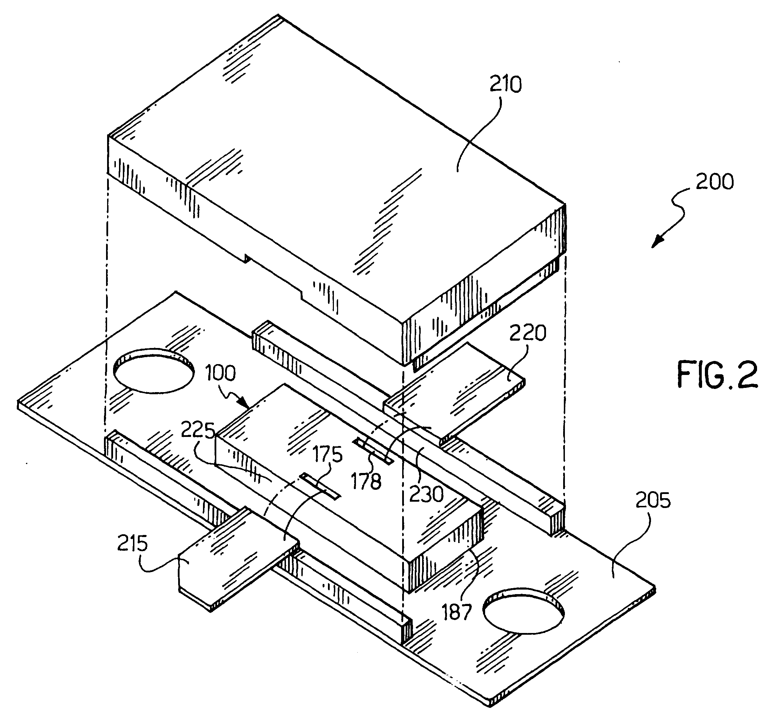

With reference now to Fig. 2 (the elements previously shown in Fig. 1j are identified by the same reference numbers), an electronic power device 200 for radio-frequency applications is illustrated. The device 200 includes a metallic case which houses the integrated structure 100, formed by a base 205 (in which two fixing windows are made) which is closed at the top by a cover 210. The lower surface 187 of the chip is fixed on the base 205. Two insulated metallic portions 215 and 220 which project externally from the metallic case 205, 210 are also connected to the base 205. Metal wires 225 and 230 electrically connect the metallic tracks 175 and 178 to inner ends of the metallic portions 215 and 220 respectively (wire bonding). The integrated structure 100 is encapsulated in the metallic case 205, 210 by soldering the cover 210 to the base 205. The base 205 forms an external emitter terminal of the device 200, while the metallic portions 215 and 220 form the external base and collector terminals respectively. Similar considerations are applicable if another equivalent metallic case is used.

The device comprising the integrated structure according to the present invention is very simple and has extremely low parasitic inductances. Moreover, with this solution it is possible to fix the lower surface of the chip directly (by soldering, for example) to the base of the metallic case (connected to ground); consequently it is unnecessary to interpose any layer of dielectric material between the chip and the case, and the heat dissipation of the electronic device is thus improved.

Clearly, a person skilled in the art may make numerous modifications and changes to the integrated power structure for radio-frequency applications described above, in order to meet contingent and specific requirements, all such modifications and changes being contained within the scope of protection of the invention, as defined by the following claims.

## Claims

1. Integrated power structure (100) for radio-frequency applications, formed in a chip of semiconductor material comprising, between a first (187) and a second (184) surface which are opposite each other, a substrate (103) on which at least one epitaxial layer (106, 112) is grown, the integrated structure (100) including at least one transistor (Tp) formed in an insulated portion (109, 142) of the chip and having a power terminal (E) located on the second surface (184),
characterized in that
it includes at least one connection region (130, 136) in contact with the power terminal (E) and extending from the second surface (184) to the substrate (103) to electrically connect the power terminal (E) to the first surface (187), the at least one connection region (130, 136) comprising a groove (127) which extends from the second surface (184) to the substrate (103) and is filled with doped polysilicon (130).

2. Integrated structure (100) according to Claim 1, in which the width of the groove (127) is substantially less than its depth.

3. Integrated structure (100) according to Claim 1 or 2, in which the at least one connection region (130, 106) consists of a single region arranged, in plan view, in the form of a frame which completely surrounds the at least one transistor (Tp).

4. Integrated structure (100) according to Claim 1 or 2, in which the at least one connection region (130, 106) consists of a plurality of regions connected in parallel between the power terminal (E) and the first surface (187).

5. Integrated structure (100) according to any one of Claims 1 to 4, in which the at least one epitaxial layer (106, 112) consists of a first epitaxial layer (106) located on the substrate (103) and a second epitaxial layer (112) located on the first epitaxial layer (106), the polysilicon (130), the substrate (103), the first (106) and the second (112) epitaxial layer being doped with impurities having a first type of conductivity (P).

6. Integrated structure (100) according to Claim 5, in which the first (106) and the second (112) epitaxial layer have a resistivity greater than 0.2 Ωm.

7. Integrated structure (100) according to Claim 5 or 6, in which the at least one transistor (Tp) is of the bipolar type and has a collector region (109, 142, 121, 154) having a second type of conductivity (N) which includes a buried region (109) between the first (106) and the second (112) epitaxial layer, a collector connection region (142) extending from the second surface (184) to an edge portion of the buried region (109), an internal region (121) delimited by the second surface (184), by the buried region (109) and by the collector connection region (142), and a selective collector region (154) extending from the second surface (184) to the buried region (109) and located, in plan view, inside the collector connection region (142), a base region (157, 159, 145) having the first type of conductivity (P) which includes an intrinsic base region (157) extending from the second surface (184) into the selective collector region (154), an extrinsic base region (159) extending from the second surface (184) into the internal region (121) and located, in plan view, around the intrinsic base region (157), and a layer of polysilicon (145) in contact on the second surface (184) with the extrinsic base region (159), and an emitter region (163, 166) having the second type of conductivity (N) which includes a junction region (166) extending from the second surface (184) into the intrinsic base region (157) and a polysilicon region (163) in contact on the second surface (184) with the junction region (166), the power terminal being an emitter terminal (E) in contact with the polysilicon region (163) and the bipolar transistor (Tp) having a collector terminal (C) and a base terminal (B) located on the second surface (184) in contact, respectively, with the collector connection region (142) and with the polysilicon layer (145).

8. Integrated structure (100) according to Claim 7, in which the buried region (109) and the collector connection region (142) have a concentration of (N+) impurities substantially greater than a concentration of (N-) impurities of the internal region (121).

9. Electronic power device (200) for radio-frequency applications, comprising a metallic case (205, 210) which houses the integrated structure (100) according to any one of Claims 1 to 8, the first surface of the chip (187) being fixed directly to the metallic case (205).

10. Method for producing an integrated power structure (100) for radio-frequency applications, comprising the phases of:
providing a chip of semiconductor material, comprising, between a first (187) and a second (184) surface which are opposite each other, a substrate (103) on which at least one epitaxial layer (106, 112) is grown,
forming, in an insulated portion (109, 142) of the chip, a transistor (Tp) having a power terminal (E) located on the second surface (184),
characterized by the phases of
forming at least one connection region (130, 136) in contact with the power terminal (E) and extending from the second surface (184) to the substrate (103) to electrically connect the power terminal (E) to the first surface (187), the at least one connection region (130, 136) being made by forming a groove (127) which extends from the second surface (184) to the substrate (103), and by filling the groove (127) with doped polysilicon (130).
